Europäisches Patentamt

European Patent Office

Office européen des brevets

(19)

(11) Publication number: 0 319 125
A2

# EUROPEAN PATENT APPLICATION

(21) Application number: 88308476.6

(22) Date of filing: 14.09.88

(51) Int. Cl.⁴: G01R 31/28

(30) Priority: 04.12.87 GB 8728444

(43) Date of publication of application:
07.06.89 Bulletin 89/23

(84) Designated Contracting States:
AT BE CH DE ES FR GB GR IT LI LU NL SE

(71) Applicant: PLESSEY OVERSEAS LIMITED
Vicarage Lane
Ilford Essex IGI 4AQ(GB)

(72) Inventor: Wood, Paul
35 Hagland Copse
Pennington Lymington, S041 8DR(GB)

(74) Representative: Elliott, Frank Edward
The Plessey Company plc. Intellectual
Property Department Vicarage Lane
Ilford, Essex IG1 4AQ(GB)

(54) Analogue circuit element and chain for testing an analogue circuit.

(57) An analogue circuit element and an analogue circuit chain, comprising a plurality of elements, for testing an analogue circuit. The element comprises a plurality of comparators, and a number of store means and switching means coupled together such that the switching means is operable for selecting a buffer mode and a sampling mode. The elements are coupled in series providing the chain with one input and one output. The chain is coupled to and formed integrally with a number of analogue circuits for testing and for buffering between the analogue circuits.

EP 0 319 125 A2

## ANALOGUE CIRCUIT ELEMENT AND CHAIN FOR TESTING AN ANALOGUE CIRCUIT

The present invention relates to an analogue circuit element and further relates to an analogue circuit chain, comprising a plurality of elements, for testing an analogue circuit.

Often, it is advantageous to be able to test an analogue circuit for, e.g. it's steady state, impulse or a.c. voltage response. One previously proposed means for testing the analogue circuit entails the use of a roving probe, otherwise known as a bed of nails technique. The probe can test or sample the analogue voltage at various nodes in the circuit. However, the probe is intrinsically external to the analogue circuit and requires more than one input and output, which not only complicates the test but also adds to uncertainties to any results.

A known means for testing with logical voltages in a digital circuit includes a digital chain,which usually comprises a series arrangement of D-type flip flops, having one input and one ouptut. The digital chain is constructed integrally with the digital circuit under test. The chain applies logic voltages to the digital circuit ,via the sole input and output, to test it's response to these logic voltages. Hitherto, this means of testing has not been applied to analogue circuits due to the incompatability of testing with analogue voltages.

The present invention, therefore, aims to provide an analogue circuit element and an analogue circuit chain for testing an analogue circuit, whilst obviating the aforementioned difficulties.

According to the present invention there is provided an analogue circuit element comprising a plurality of comparators, a number of store means and a number of switching means, electrically coupled together to define a circuit arrangement, in which the switching means is operable for selecting a buffer operative mode or a sampling operative mode for the circuit arrangement. Advantageously the comparators and the switching means are coupled alternately in series, to define a sequence having a first comparator at the beginning of the sequence and a last comparator at the end of the sequence for providing an output.

Each store means may be coupled in parallel between adjacent comparators and further may be coupled between adjacent comparators having each switching means preceding each store means in the sequence.

Preferably the switching means is coupled to a coordinating means for affording a logic signal to the switching means and for coordinating the said switching means thereby enabling the switching means to select the buffer operative mode or the sampling operative mode.

Advantageously two inputs may be coupled to a selecting means for selecting one of the said inputs and for affording the selected input to the first comparator of the sequence. The selecting means may comprise a first switch coupled to one of the inputs, a further switch coupled to the other input, a further logic signal coupled to one of the first or further switches and coupled to the other switch via a further inverter.

Furthermore, according to the present invention there is also provided an analogue circuit chain comprising a plurality of analogue circuit elements, wherein each element comprises a plurality of comparators, a number of store means and a number of switching means, electrically coupled together to define a circuit arrangement, in which the switching means is operable for selecting a buffer operative mode and a sampling operative mode for the circuit arrangement, the elements being electrically coupled is series providing a first and last element, having one input and one output for the chain, and the chain being electrically coupled to, and formed integrally with a number of analogue circuits for testing and for buffering between the said analogue circuits.

By way of example, embodiments of the present invention will be described with reference to the accompanying drawings of which:-

Figure 1 is a circuit diagram of an analogue circuit element in accordance with the present invention;

Figure 2 is a flow diagram of an analogue circuit chain;

Figure 3 is a flow diagram of an analogue circuit chain in accordance with a first embodiment;

Figure 4 is a flow diagram of an analogue circuit chain in accordance with a second embodiment;

Figure 5 a and b are schematic diagrams of a test voltage applied by the analogue circuit chain shown in Figure 4;

Figure 6 is a schematic diagram of an analogue circuit chain on a p.c.b. in accordance with a third embodiment; and,

Figure 7 a, b, c and d are schematic diagrams of a test voltage applied by the analogue circuit chain shown in Figure 6.

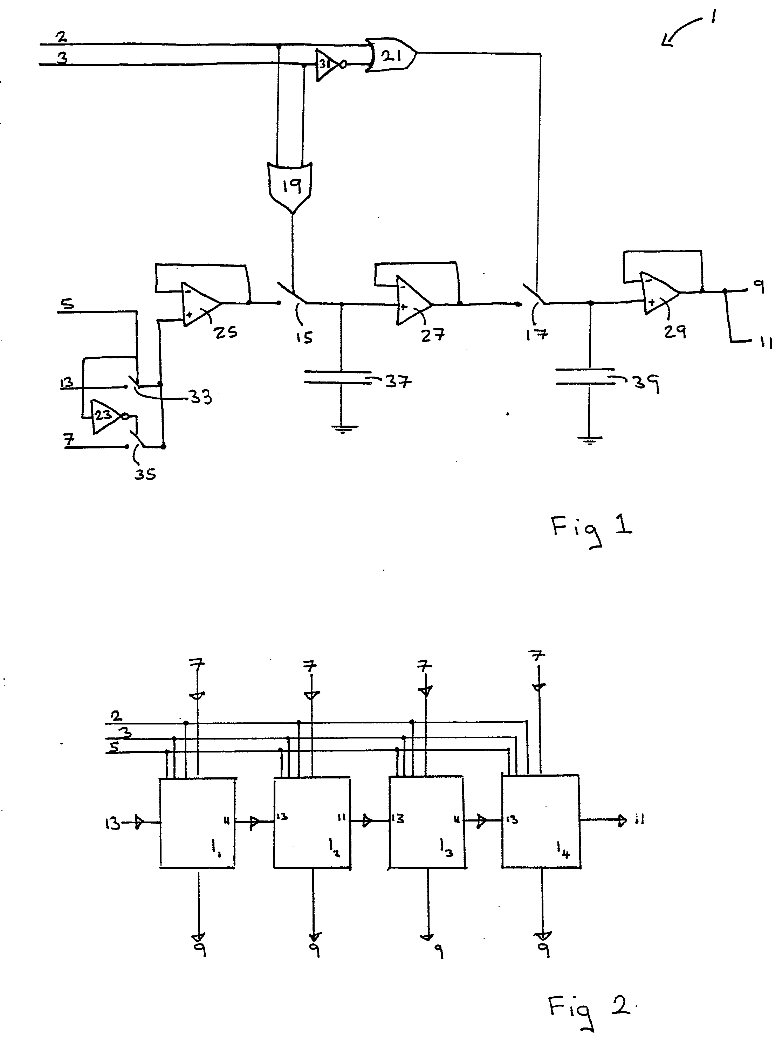

Figure 1 illustrates a preferred embodiment of the present invention showing a circuit diagram of an analogue circuit element 1. Operating conditions for the element 1 will now be described, followed by a description of it's buffer operative mode and it's sampling operative mode. The element 1 is controlled by digital signals on a test bar 2, a scan clock bar (SCLK) 3 and a selecting means known as a scan/data bar 5. The element 1 is arranged between components of an analogue circuit (not shown) such that a first input known as a datain 7 is connected to the output of one component and a first output known as a dataout 9 is connected to the input of another component.

Test voltages, normally analogue voltages, are sequentially applied to the analogue circuit (not shown) for sampling the circuit's response. Such a test voltage is applied by one element 1 via an output known as a scanout terminal 11 and the response is sampled by another element 1 via a further input known as a scanin terminal 13.

During the buffering operative mode, the element 1 acts as an analogue buffer circuit and enables a voltage applied at the datain 7 to be afforded to the dataout 9. In this mode the test bar 2 is high which closes analogue switches 15 and 17, via OR gates 19 and 21. The scan/data bar 5 is maintained at a low which selects the datain 7 via the NOT gate 23. Data present at the datain 7, in the form of an analogue voltage, is buffered by differential amplifiers 25, 27, 29 and eventually appears at dataout 9.

During the sampling operative mode, the test bar 2 is low and in combination with a NOT gate 31, enables the switches 15 and 17 to close on opposite phases of the SCLK 3. The scan/data 5 selects the datain 7 or the scanin 13 by way of analogue switches 33 and 35. By way of example let the datain 7 be selected and so any voltage present on the datain 7, is buffered by the differential amplifier 25 and appears at the switch 15 At a rate suitable for sampling, the SCLK 3 goes high, the switch 15 closes and a capacitor 37 is charged to the voltage of the datain 7. This voltage is buffered by the differential amplifier 27 and appears at the switch 17 which is currently open.

In the following phase the SCLK 3 goes low, which opens switch 15 and closes switch 17. The voltage stored by the capacitor 37 is a sample of the datain 7 and is independent of it. A capacitor 39 charges to the same voltage stored in capacitor 37. This voltage is buffered by the differential amplifier 29 and appears at the dataout 9.

Similarly when the scanin 13 is selected, the sampling operation of the scanin 13 occurs in the same way.

Having completed the sampling operation, the SCLK 3 goes high thus opening gate 17 in preparation for further sampling whilst maintaining the output voltage at dataout 9 or scanout 11.

The element 1 could therefore be said to act as a master slave sample and hold circuit. The low to high to low sequence on the SCLK 3 samples the inputs 7, 13 and passes it to the outputs 9, 11. This master slave configuration is required to enable a plurality of elements 1 to be cascaded. The master slave configuration enables each element 1 to store voltages and thus data from each respective element can be shifted along the cascade without loss of data.

There is shown in Figure 2, four elements 1 cascaded to form an analogue circuit chain having one input and one output. Each element 1 shares the common test bar 2, SCLK 3 and scan/data bar 5, thus enabling synchronisation of the elements 1. Furthermore, the elements 1 are interlinked serially via the scanin 13 and scanout 11. Test voltages, which may be analogue, can be applied serially to the scanin 13 of element 1, sampled by the other elements $1_2$, $1_3$, and appear at the scanout 11 of element $1_4$.

Obviously any number of elements 1 may be used to form the chain and the number used is generally determined by the application of the chain.

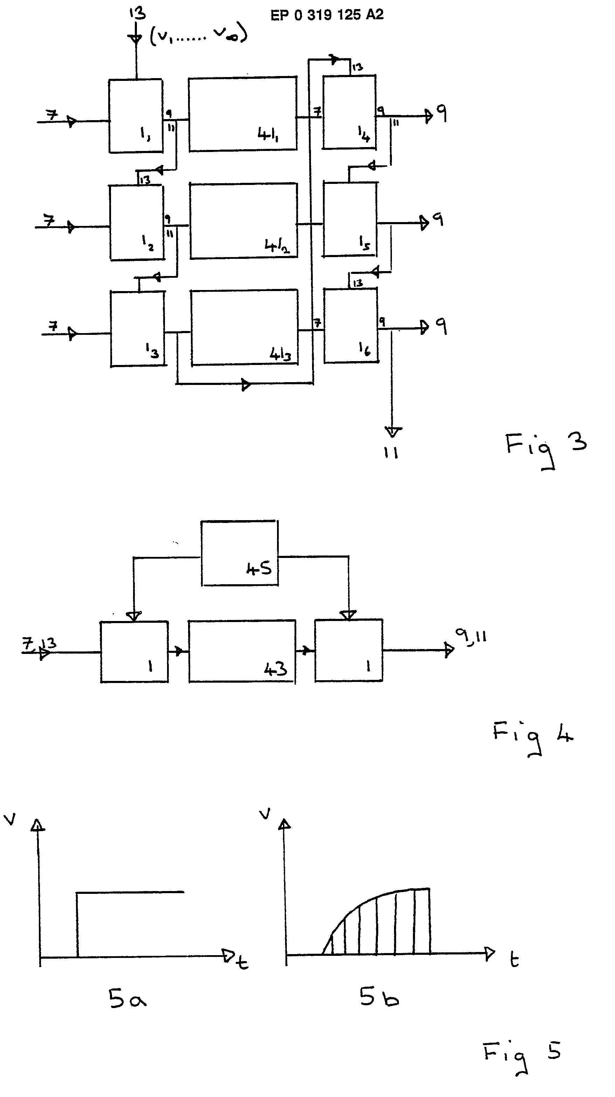

One such application is shown in Figure 3, where six elements $1_{1-6}$ are used to test three analogue circuits $41_{1-3}$. The common test bar 2, SCLK 3 and scan/data bar 5 are not shown for simplicity. One way of testing the circuits $41_{1-3}$ for their response to d.c. voltage is described below.

D.C. voltages are applied serially to the chain via the scanin 13 of the element $1_1$. Let the voltages applied form the sequential set ($V_1$ $V_2$............$V_n$).

1. During the first phase $V_1$ is applied to the scanin 13 of the element $1_1$.

2. The voltage $V_1$ is sampled and during the second phase appears at the scanout 11. This voltage $V_1$ thus appears at the input of the analogue circuit $41_1$ and the scanin 13 of the element $1_2$. Meanwhile the next voltage $V_2$ is applied to element $1_1$.

3. During the third phase, the analogue circuit $41_1$ responds to this voltage $V_1$ and provides an output $V_1'$ which appears at the data in 7 of the element $1_4$. The element $1_2$ samples the voltage $V_1$ and it appears at it's scanout 11. Also the element $1_1$ samples the voltage $V_2$ and it appears at it's scanout 11, and the voltage $V_3$ is applied to the scanin 13 of element $1_1$.

4. During the fourth phase the analogue circuit $41_1$ responds to the voltage $V_2$ and provides an output $V_2'$. The element $1_4$ buffers the voltage $V_1'$ and appears at its scanout 11. The element $1_2$ samples the voltage $V_2$ and it appears at it's scanout 11. The voltage $V_3$ is buffered by element $1_1$ and appears at the input of $41_1$ and the scanin 13 of element $1_2$. The element $1_1$ samples the next voltage $V_4$ and it appears at it's scanout 11.

During the subsequent phases, d.c. voltages are shifted along the chain and after sampling by

the elements $1_4$, $1_5$, $1_6$ voltages appear serially at the scanout 11 of the element $1_6$. These voltages can then be analysed to determine the response of the analogue circuits $41_{1-3}$ to the sequential set of d.c. voltages.

The second embodiment of the present invention is shown in Figure 4. In this application one element 1 is coupled to the input of a filter 43 and another element 1 to the output of the filter 43. Both elements 1 are coupled to an external clock 45 for synchronisation of the test. A step function, such as shown in Figure 5a, is applied to the filter 43 via the first element 1. Then the second element 1 samples the output from the filter 43 at a frequency determined by the external clock 45. After analysis of the voltages appearing at the output 9, 11 of the second element 1, the response of the filter 43 to the step function can be determined. A typical response is shown in Figure 5b and any faulty components or connections in the filter 43 will be revealed by this response.

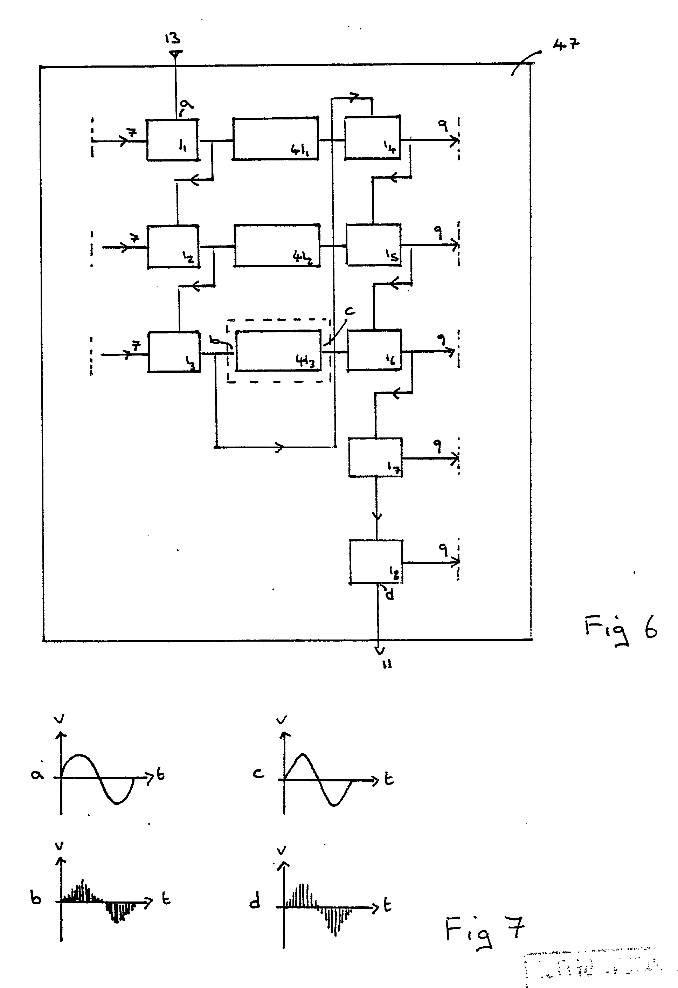

The present invention also enables the a.c. response of a circuit to be analysed as shown in Figure 6. In this embodiment, an a.c. waveform is applied to the element $1_1$ of the chain in order to test the response of the analogue circuit $41_3$ For each element 1 the scanin 13 is selected, except element $1_6$ which has datain 7 selected. The a.c. waveform as it passes through the circuit is shown in Figure 7, where like letters indicate the voltage response at that stage.

Again any faulty components or connections are revealed by the waveform appearing at the output of the chain. Furthermore, Figure 6 illustrates the chain in relation to the analogue circuits 41 and the analogue circuit under test $41_3$ all arranged on a printed circuit board 47 whilst providing just one input 13 and one output 11 for testing.

Advantageously, whenever the circuit being tested is buried in other circuits, a number of elements 1 can be interlinked providing a long chain having one input and one output which enables access to the circuit under test.

The present invention, therefore, provides an integral circuit chain for testing an analogue circuit. However, when the analogue circuit is not under test, the elements isolate the analogue circuits and act as buffers between these analogue circuits. Consequently, the present invention is especially applicable to testing surface mounted components.

It will be appreciated by a person skilled in the art that the foregoing description has been given by way of example only and modifications may be made without departing from the scope of the present invention.

## Claims

1. An analogue circuit element comprising a plurality of comparators, a number of store means and a number of switching means, electrically coupled together to define a circuit arrangement, in which the switching means is operable for selecting a buffer operative mode and a sampling operative mode for the circuit arrangement.

2. An element according to Claim 1, in which the comparators and the switching means are coupled alternately in series, to define a sequence having a first comparator at the beginning of the sequence and a last comparator at the end of the sequence for providing an output.

3. An element according to Claim 2, in which each store means is coupled in parallel between adjacent comparators.

4. An element according to Claim 2 or Claim 3 in which each store means is coupled in parallel between adjacent comparators having each switching means preceding each store means in the sequence.

5. An element according to any one of the preceding claims in which each switching means is coupled to a co-ordinating means for affording a logic signal to the switching means and for co-ordinating the said switching means thereby enabling the switching means to select the buffer operative mode or the sampling operative mode.

6. An element according to Claim 5, in which the co-ordinating means comprises first and further gates coupled to the logic signal, a clock coupled to the first gate, the clock coupled to the further gate via an inverter, and the output from the first gate is coupled to alternate switching means and the output from the further gate is coupled to the other alternative switching means, such that adjacent switching means are coupled to different gate outputs.

7. An element according to Claim 4 or Claim 5, in which the buffer operative mode is selected when the logic signal is high and the sampling operative mode is selected when the logic signal is low.

8. An element according to any one of Claims 2 to 7, in which two inputs are coupled to a selecting means for selecting one of the said inputs and for affording the selected input to the first comparator of the sequence.

9. An element according to Claim 8, in which the selecting means comprises a first switch coupled to one of the inputs, a further switch coupled to the other input, a further logic signal coupled to one of the first or further switches and coupled to the other switch via a further inverter.

10. An element according to any one of the preceding claims, in which the comparators each comprise a differential amplifier having a feedback loop from the output to the negative input of the differential amplifier.

11. An element according to any one of the preceding claims, in which the store means each comprise a capacitor and each capacitor having one electrode coupled to earth.

12. An element according to any one of the preceding claims, in which the circuit arrangement in the sampling operative mode is a master slave sample and hold circuit.

13. An analogue circuit chain comprising a plurality of analogue·circuit elements, wherein each element comprises a plurality of comparators, a number of store means and a number of switching means, electrically coupled together to define a circuit arrangement, in which the switching means is operable for selecting a buffer operative mode and a sampling operative mode for the circuit arrangement, the elements being electrically coupled is series providing a first and last element, having one input and one output for the chain, and the chain being electrically coupled to, and formed integrally with a number of analogue circuits for testing and for buffering between the said analogue circuits.

14. A chain according to Claim 13, in which the comparators and the switching means of each element are coupled alternatively in series to define a sequence having a first comparator at the beginning of the sequence to which is selectively afforded a first or a further input and a last comparator at the end of the sequence for providing a first and a further output, and having each store means coupled in parallel between adjacent comparators, whereby the first input of each element is coupled to a respective analogue circuit and the first output of each element is coupled to another respective analogue circuit and the further input of the first comparator of the first element defines the input to the chain and the further output of the last comparator of the last element defines the output to the chain and for each remaining element the further input is coupled to the further output of the preceding element in the chain and the further output is coupled to the further input of the suceeding element in the chain.

15. A chain according to Claim 13 or Claim 14, in which a test voltage is applied at the input of the chain to test at least one analogue circuit.

16. A chain according to Claim 15, in which the test voltage is an a.c. voltage.

17. A chain according to Claim 15, in which the test voltage is a d.c. voltage.

18. A chain according to any one of claims 15 to17, in which the test voltage is a step function.

19. A chain according to any one of Claims 13 to 18, in which for each element the switching means is coupled to a co-ordinating means responsive to a logic signal for affording the logic signal to the switching means and which is responsive to a clock for coordinating the switching means, whereby each co-ordinating means 'of each element is coupled to the logic signal and the clock.

20. A chain according to any one of Claims 13 to 19, in which for each element the comparators each comprise a differential amplifier having a feedback loop from the output to the negative input of the differential amplifier.

21. A chain according to any one of Claims 13 to 20, in which for each element the store means each comprise a capacitor, and each capacitor having one electrode coupled to earth.

22. An analogue circuit element substantially as hereinbefore described with reference to Figure 1.

23. An analogue circuit chain substantially as hereinbefore described with reference to any one of Figures 2 to 7.

24. A printed circuit board having at least one circuit and an analogue circuit chain in accordance with any one of claims 13 to 23.

Fig 1

Fig 2

Fig 3

Fig 4

5a

5b

Fig 5

Fig 6

Fig 7